Europäisches Patentamt

(19) European Patent Office

Office européen des brevets

(11) Publication number: **0 127 415**

**A2**

# EUROPEAN PATENT APPLICATION

(12)

(21) Application number: 84303427.3

(22) Date of filing: 21.05.84

(51) Int. Cl.³: **G 03 F 7/10**

(30) Priority: 27.05.83 US 498906

(43) Date of publication of application:
05.12.84 Bulletin 84/49

(84) Designated Contracting States:
BE DE FR GB IT NL SE

(71) Applicant: AMERICAN TELEPHONE AND TELEGRAPH
COMPANY
550 Madison Avenue
New York, NY 10022(US)

(72) Inventor: Craighead, Harold Gene
10 Rutgers Drive
Fair Haven New Jersey 07701(US)

(72) Inventor: Howard, Richard Edwin
12 McCampbell Road
Holmdel New Jersey 07733(US)

(72) Inventor: Jackel, Lawrence David
31 Stoney Brook Road
Holmdel New Jersey 07733(US)

(72) Inventor: White, Jonathan Curtis
113 Jumping Brook Road
Lincroft New Jersey 07738(US)

(74) Representative: Johnston, Kenneth Graham et al,
Western Electric Company Limited 5 Mornington Road
Woodford Green Essex, IG8 OTU(GB)

(54) A resist for vacuum ultraviolet lithography.

(57) This invention concerns with patterning a device substrate by depositing a layer of resist over the substrate and selectively exposing the resist to a ultraviolet radiation. The improvement resides in the use of vacuum ultraviolet radiation and of a resist comprising a copolymer of methylmethacrylate and methacrylic acid in which the methacrylic acid is present in concentration of from 0.05 to 40 percent by weight.

EP 0 127 415 A2

- 1 -

# A RESIST FOR VACUUM
# ULTRAVIOLET LITHOGRAPHY

## Technical Field

The present invention relates to resist material for lithographic use with vacuum ultraviolet radiation, i.e., radiation wherein the wavelength is from 100-200 nanometers.

## Background of the Invention

Lithography is a standard technique for fabricating the minuscule patterns required in integrated circuits and other miniature devices. Pursuant to this technique, a resist-coated device substrate is selectively exposed to a source of electromagnetic radiation via a mask. The irradiated regions of the resist layer suffer a chemical change which makes them either more soluble or less soluble than the nonirradiated regions in a developer. The developer is then used to remove the more soluble resist regions, which are the irradiated regions in a "positive" resist and the nonirradiated regions in a "negative" resist. The openings thus formed in the resist layer provide a masking layer for subsequent etching or deposition of material.

It is well-known that the undesirable interference and diffraction effects occurring in lithography are directly related to the radiation wavelength. Accordingly, there have been extensive efforts to develop lithographic systems which utilize extremely short wavelength radiation. For example, there have been extensive efforts to develop lithographic systems utilizing x-rays as the radiation source. Such x-ray systems, however, are often unsuitable for production as they require extensive equipment to generate the necessary radiation intensity and the mask structure is extremely fragile.

More recently, there have been efforts to develop vacuum ultraviolet (VUV) lithographic systems which utilize radiation having a wavelength in the range of 100 to 200 nanometers. See, for example, a pending U.S. application Serial No. 495,064 filed May 13, 1983 by applicants entitled "Mask Structure for Vacuum Ultraviolet Lithography". While vacuum ultraviolet systems utilize a mechanically robust mask structure and can routinely provide submicron pattern features, many resist materials used in other lithographic systems are either insensitive to the VUV radiation or rapidly become opaque to the VUV radiation at low exposure doses. Consequently, at best, only an extremely thin resist layer can be irradiated. This limitation in resist thickness severely circumscribes the thickness of material which can be precisely deposited or removed from the device substrate and, therefore, the applicability of VUV lithography for fabricating certain miniature semiconductor, optical or acoustic-wave devices.

## Summary of the Invention

The present invention overcomes the problems of the prior art through the use of a copolymer of methylmethacrylate and methacrylic acid as the resist material for VUV lithography. In accordance with the present invention, a device substrate is provided with a layer of the above-identified copolymer. To pattern this resist layer, the resist layer is selectively exposed to VUV radiation via a mask. The irradiated copolymer is then removed using a known developer.

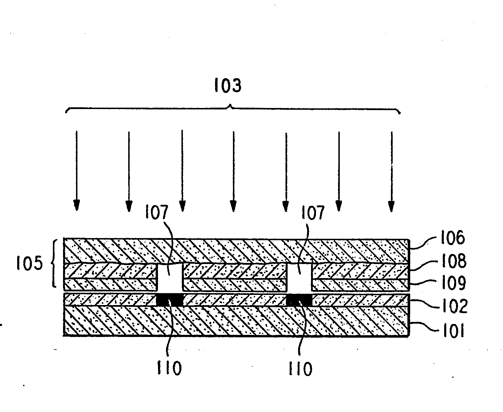

## Brief Description of the Drawing

The single Figure is a cross-sectional view depicting patterning of a device substrate with a resist in accordance with the present invention.

## Detailed Description

As will be described hereinbelow, it has been found by the present inventors that a copolymer of methylmethacrylate (MMA) and methacrylic acid (MAA) provides a positive VUV resist, i.e., a material which becomes more soluble in a developer after exposure to VUV radiation. The Figure shows the application of this material to the patterning of a device substrate. As shown, device substrate 101 is covered with a resist layer 102 comprising the above-identified copolymer. For purposes of simplicity, resist layer 102 is shown in contact with device substrate 101. Of course, resist layer 102 can be over one or more intermediate material layers which were previously formed on device substrate 101.

Resist layer 102 is selectively exposed to VUV radiation 103 via mask 105. Mask 105 comprises an alkaline-earth, alkaline-metal halide or other sufficiently transparent substrate 106 and at least one patterned material layer which is opaque to the VUV radiation except for regions 107. Consequently, VUV radiation passes through mask 105 and irradiates areas 110 of resist layer 102. Irradiated areas 110 can be removed using a developer, such as 30% ethylene glycol monoethylether 70% methanol (by volume). In the illustrated mask, mask substrate 106 is covered with a layer of polyimide 108 and a layer of germanium 109. Further details on this mask structure are disclosed in applicants' previously referenced copending application entitled "Mask Structure for Vacuum Ultraviolet Lithography".

To test the resolution capability of the VUV resist, a copolymer of 90.8% methylmethacrylate and 9.2% methacrylic acid (by weight) was spun onto a device substrate from a 5.4% (by weight) solution in acetic acid. The thickness of the resist layer was .2 micrometers. After baking the resist in air at $160^{\circ}$C for 45 minutes, a pattern of lines as small as .15 micrometers was formed by exposing the resist layer to a dose of approximately .2 joule/$cm^2$ from a source of 150 nanometer radiation and then developing in 30% ethylene glycol monoethylether 70% methanol (by volume) for 4 seconds.

- 4 -

Tests of the exposure and development characteristics of the MMA/MAA copolymer were also made for 9.2% and 25% (by weight) acid concentrations and compared against a 0% acid concentration, i.e., polymethylmethacrylate (PMMA). For an exposure dose of approximately .2 joule/cm$^2$, a fine edge was developed. The development depths were .05 micrometers, .30 micrometers and .36 micrometers for 0%, 9.2% and 25% acid concentrations, respectively. It is obvious that while de minimis acid concentrations, i.e., less than .05%, do not significantly affect the development depth, increasing the acid concentration above this threshold increases the development depth. As a practical matter, however, acid concentrations greater than 40% are not suitable for many device fabrication applications as the copolymer becomes increasingly soluble in polar solvents such as methanol.

## Claims

1. A method of patterning a device substrate comprising the steps of

depositing a layer of resist over said device substrate,

and selectively exposing said resist layer to a ultraviolet radiation

CHARACTERIZED BY

selecting a resist comprising a copolymer of methylmethacrylate and methacrylic acid, the concentration of methacrylic acid by weight being from .05% to 40%, and

conducting said exposing with a radiation having a wavelength in the vacuum ultraviolet region of the electromagnetic spectrum.

2. The method according to claim 1,

CHARACTERIZED BY

developing said exposed resist layer in a developer comprising ethylene glycol monoethylether.

1/1

103

107     107

106
105 {   108
        109
        102
        101

110     110